# EUROPEAN PATENT APPLICATION

(11) **EP 4 379 511 A2**
(43) Date of publication of application: **05.06.2024**
(21) Application number: 24170861.9
(22) Date of filing: 20.11.2020
(51) Int. Cl.: G06F 3/01

(54) **BRAIN-COMPUTER INTERFACE**

(30) Priority: 20.11.2019 US 201962938112 P
(62) Divisional of application: 20811278.9
(71) Applicant: NEXTMIND SAS, 75009 Paris (FR)
(72) Inventor: KOUIDER, Sid, 75009 Paris (FR); STEINMETZ, Nelson, 75009 Paris (FR); ZERAFA, Robin, 75009 Paris (FR); JOLLET, Adrien, 75009 Paris (FR); ZHANG, Hao, 75009 Paris (FR); RECHKE, Bastien, 75009 Paris (FR); PLOYART, Guillaume, 75009 Paris (FR)
(74) Representative: Morgan, Dylan Sean Thomas Tobin

(57) **Abstract**

A system and method relating to a brain-computer interface in which visual stimuli are presented in direct association with real world objects such that the intention of the user with respect to objects in the real world can be inferred without the interposition of a screen or other display device.

## Description

### Cross-Reference to Related Applications

This application claims the benefit of priority from U.S. Provisional Patent Application Serial Number 62/938,112, filed November 20, 2019, and entitled "BRAIN-COMPUTER INTERFACE", which is incorporated by reference herein in its entirety.

### Technical field of the invention

The present invention relates to the control of real-world objects through brain-computer interfaces involving visual sensing.

### State of the art

In visual brain-computer interfaces (BCIs), neural responses to a target stimulus, generally among a plurality of generated visual stimuli presented to the user, are used to infer (or "decode") which stimulus is essentially the object of focus at any given time. The object of focus can then be associated with a user-selectable or -controllable action.

Neural responses may be obtained using a variety of known techniques. One convenient method relies upon surface electroencephalography (EEG), which is non-invasive, has fine-grained temporal resolution and is based on well-understood empirical foundations. Surface EEG makes it possible to measure the variations of diffuse electric potentials on the surface of the skull (i.e. the scalp) of a subject in real-time. These variations of electrical potentials are commonly referred to as electroencephalographic signals or EEG signals.

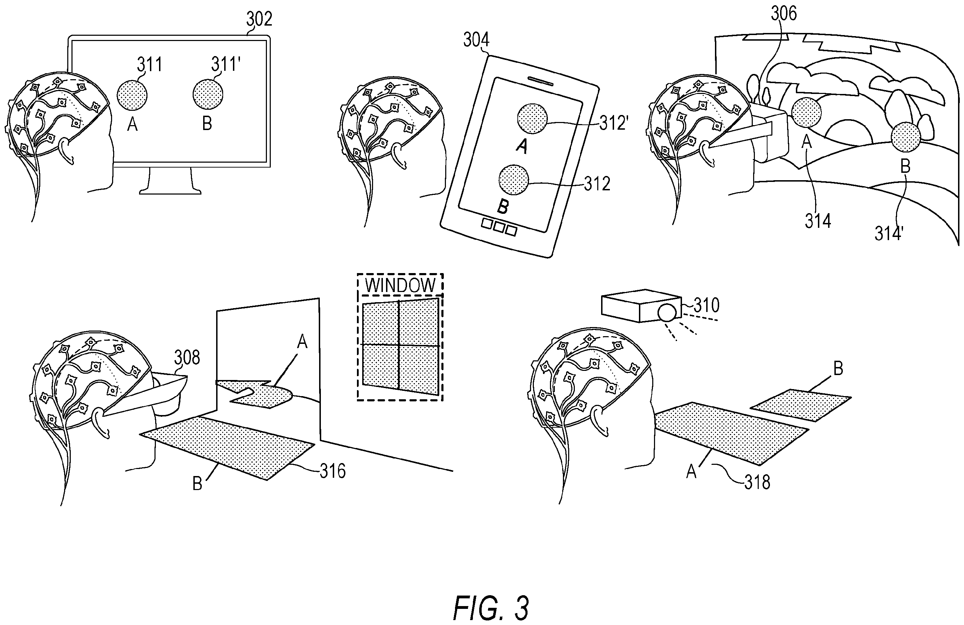

In a typical BCI, visual stimuli are presented in a display generated by a display device. Examples of suitable display devices (some of which are illustrated in FIG. 3) include television screens & computer monitors 302, projectors 310, virtual reality headsets 306, interactive whiteboards, and the display screen of tablets 304, smartphones, smart glasses 308, etc. The visual stimuli 311, 311', 312, 312', 314, 314', 316 may form part of a generated graphical user interface (GUI) or they may be presented as augmented reality (AR) or mixed reality graphical objects 316 overlaying a base image: this base image may simply be the actual field of view of the user (as in the case of a mixed reality display function projected onto the otherwise transparent display of a set of smart glasses) or a digital image corresponding to the user's field of view but captured in real time by an optical capture device (which may in turn capture an image corresponding to the user's field of view amongst other possible views).

Inferring which of a plurality of visual stimuli (if any) is the object of focus at any given time is fraught with difficulty. For example, when a user is facing multiple stimuli, such as for instance the digits displayed on an on-screen keypad, it has proven nearly impossible to infer which one is under focus directly from brain activity at a given time. The user perceives the digit under focus, say digit 5, so the brain must contain information that distinguishes that digit from others, but current methods are unable to extract that information. That is, current methods can infer that a stimulus has been perceived, but they cannot determine which specific stimulus is under focus using brain activity alone.

To overcome this issue and to provide sufficient contrast between stimulus and background (and between stimuli), it is known to configure the stimuli used by visual BCIs to blink or pulse (e.g. large surfaces of pixels switching from black to white and vice-versa) so that each stimulus has a distinguishable characteristic profile over time. The flickering stimuli give rise to measurable electrical responses. Specific techniques monitor different electrical responses, for example steady state visual evoked potentials (SSVEPs) and P-300 event related potentials. In typical implementations, the stimuli flicker at a rate exceeding 6 Hz. As a result, such visual BCIs rely on an approach that consists of displaying, in a display device, the various stimuli discretely rather than constantly, and typically at different points in time. Brain activity associated with attention focused on a given stimulus is found to correspond (i.e. correlate) with one or more aspect of the temporal profile of that stimulus, for instance the frequency of the stimulus blink and/or the duty cycle over which the stimulus alternates between a blinking state and a quiescent state.

Thus, decoding of neural signals relies on the fact that when a stimulus is turned on, it will trigger a characteristic pattern of neural responses in the brain that can be determined from electrical signals, i.e. the SSVEPs or P-300 potentials, picked up by electrodes of an EEG device, the electrodes of an EEG helmet, for example. This neural data pattern might be very similar or even identical for the various digits, but it is time-locked to the digit being perceived: only one digit may pulse at any one time so that the correlation with a pulsed neural response and a time at which that digit pulses may be determined as an indication that that digit is the object of focus. By displaying each digit at different points in time, turning that digit on and off at different rates, applying different duty cycles, and/or simply applying the stimulus at different points in time, the BCI algorithm can establish which stimulus, when turned on, is most likely to be triggering a given neural response, thereby allowing a system to determine the target under focus.

Visual BCIs have improved significantly in recent years, so that real-time and accurate decoding of the user's focus is becoming increasingly practical. Nevertheless, the constant blinking of the stimuli, sometimes all over the screen when there are many of them, is an intrinsic limitation for a large-scale use of this technology. Indeed, it can cause discomfort and mental fatigue, and, if sustained, physiological responses such as headaches. In addition, the blinking effect can impede the ability of the user to focus on a specific target, and the system to determine the object of focus quickly and accurately. For instance, when a user tries to focus on digit 5, the other (i.e., peripheral) digits act as distractors, drawing the user's attention momentarily, and induce interference in the user's visual system. This interference in turn impedes the performance of the BCI. Consequently, there is a need for an improved method for differentiating screen targets and their display stimuli in order to determine which one a user is focusing on.

The requirement of a display device of some kind in which to present visual stimuli places a limitation on the application of the foregoing techniques. In particular, suitable displays may not be available or desirable. In certain applications, interacting with objects through a screen may be inconvenient or impractical. Furthermore, user acceptability of the EEG device (and its electrodes) places aesthetic constraints, as well as constraints in comfort and ease of use. In many cases, these constraints are an effective significant barrier to the adoption of EEG technology. Examples of applications where comfort over prolonged use and the need for technical assistance prevent adoption include applications such as video games, training (e.g. for health and safety or flight simulation), sleep aids, etc.

It is therefore desirable to provide brain-computer interfaces that address the above challenges.

### SUMMARY

The present disclosure relates to a brain-computer interface in which visual stimuli are presented in direct association with real world objects such that the intention of the user can be extended to objects in the real world without the interposition of a screen or other display device, offering an improved and intuitive user experience.

The present disclosure relates to techniques for applying a visual stimulus to an otherwise conventional real world object rendering the object as an object of potential interest when within the field of view of a user.

In certain embodiments, the applied visual stimulus may include the projection of an overlay image with a temporal modulation onto the real world object or objects. The modulation makes the object blink or otherwise visually alter so that the modulation acts as a stimulus for a correlated neural response in the brain of the user. The neural response may in turn be measured and decoded to determine which object of interest is the focus of the user's attention.

In other embodiments, the object itself may include one or more light sources capable of emitting light with a temporal modulation. Here too, the modulation makes the object blink or otherwise visually alter so that the modulation acts as a stimulus for a correlated neural response in the brain of the user. The neural response may in turn be measured and decoded to determine which object of interest is the focus of the user's attention.

In other embodiments, an electronic badge, separate from real world controllable objects but logically associated with at least one of them, may be provided. The electronic badge includes one or more light sources capable of emitting light with a temporal modulation. Unlike conventional screens and display devices, the electronic badge is typically small in size and may be dedicated to outputting visual stimuli. The modulation in the emitted light makes a display portion of the electronic badge blink or otherwise visually alter so that the modulation acts as a stimulus for a correlated neural response in the brain of the user. The neural response may in turn be measured and decoded to determine which electronic badge is the focus of the user's attention and, since the badge is logically associated with the real world object, thereby to determine that the real world object is the object of interest.

In each of the embodiments above, the modulation may be applied preferentially or exclusively to a high spatial frequency component of the projected overlay image.

According to a first aspect, the present disclosure relates to a brain computer interface system, comprising: at least one light emitting unit outputting a respective visual stimulus generated by a stimulus generator, the visual stimulus having a characteristic modulation; at least one controllable object configured to receive user instructions, each controllable object being associated with at least one visual stimulus; a neural signal capture device configured to capture neural signals associated with the user; an interfacing device operatively coupled to the neural signal capture device and the controllable object, the interfacing device including: a memory; and a processor operatively coupled to the memory and configured to: receive the neural signals from the neural signal capture device; determine which of the at least one visual stimuli is an object of focus of the user based on the neural signals, the object of focus being inferred from the presence in the neural signals of a component having a property associated with the characteristic modulation of the visual stimulus; and transmitting a command to the controllable object determined to be associated with the object of focus, wherein said controllable object implements an action based on said command.

In certain embodiments, implementing the action comprises controlling the controllable object to change state from a standby state.

In certain embodiments, the at least one controllable object includes the stimulus generator and the light emitting unit for outputting the visual stimulus generated by the stimulus generator.

In certain embodiments, the light emitting unit and the stimulus generator are provided in an electronic badge, the electronic badge being separate from the one or more controllable objects and the logically associated with at least one of said controllable objects. Again, the light emitting unit outputs the visual stimulus generated by the stimulus generator.

In certain embodiments, the light emitting unit is a projector or a laser display device, the projector or laser display device being operatively coupled to the stimulus generator and projecting the respective visual stimulus onto the controllable object; and wherein the controllable object reflects the projected stimulus.

In certain embodiments, the or each light emitting unit comprises at least one of: a light emitting diode (LED); an array of LEDs; a liquid crystal display (LCD) device; an organic light-emitting diode (OLED) display; active-matrix organic light-emitting diode (AMOLED) display; or an electric arc.

In certain embodiments, the system further comprises a processing device, the processing device including the stimulus generator, wherein the processing device is communicatively coupled with the interfacing device, the processing device configured to communicate information indicating the generated visual stimulus to the interfacing device.

In certain embodiments, the modulation is selectively applied to the high spatial frequency (HSF) component of the display data.

According to a second aspect, the present disclosure relates to a method of operation of a brain computer interface system, the brain computer interface system including a neural signal capture device and at least one light emitting unit for outputting a visual stimulus generated by a stimulus generator, the visual stimulus having a characteristic modulation, wherein the method comprises, in a hardware interfacing device operatively coupled to the neural signal capture device and a controllable real world object: forming an association between the controllable real world object and the at least one visual stimulus; receiving neural signals associated with a user captured by the neural signal capture device; determining which of the at least one visual stimuli is an object of focus of the user based on the neural signals, the object of focus being inferred from the presence in the neural signals of a component having a property associated with the characteristic modulation of the visual stimulus; and transmitting a command to the controllable object determined to be associated with the object of focus, thereby controlling said controllable object to implement an action based on said command.

In certain embodiments, the method further comprises implementing the action comprises controlling the controllable object to change state from a standby state.

In certain embodiments, the at least one controllable object includes the stimulus generator and the light emitting unit, and forming the association between the controllable real world object and the at least one visual stimulus includes controlling the light emitting unit to output the visual stimulus generated by the stimulus generator.

In certain embodiments, the light emitting unit and the stimulus generator are provided in an electronic badge, the electronic badge being separate from the one or more controllable objects, and forming the association between the controllable real world object and the at least one visual stimulus includes logically associating the electronic badge with the at least one controllable object and controlling the light emitting unit of the electronic badge to output the visual stimulus generated by the stimulus generator.

In certain embodiments, the light emitting unit is a projector, the projector being operatively coupled to the stimulus generator. and forming the association between the controllable real world object and the at least one visual stimulus includes controlling the projector to project the respective visual stimulus onto the controllable object, so that the controllable object reflects the projected stimulus.

In certain embodiments, the brain computer interface system further comprises a processing device, the processing device including the stimulus generator; the processing device is communicatively coupled with the hardware interfacing device, and forming the association between the controllable real world object and the at least one visual stimulus further comprises, causing the processing device to communicate information indicating the generated visual stimulus to the interfacing device.

In certain embodiments of this method, the modulation is selectively applied to the high spatial frequency (HSF) component of the display data.

According to a third aspect, the present disclosure relates to a computer-readable storage medium, the computer-readable storage medium including instructions that when executed by a machine, cause the machine to perform the method above.

### BRIEF DESCRIPTION OF THE SEVERAL VIEWS OF THE DRAWINGS

To easily identify the discussion of any particular element or act, the most significant digit or digits in a reference number refer to the figure number in which that element is first introduced.
FIG. 1 illustrates an electronic architecture for receiving and processing EEG signals according to the present disclosure;
FIG. 2 illustrates a system incorporating a brain computer interface (BCI) according to the present disclosure;
FIG. 3 illustrates various examples of display device suitable for use with the BCI system of the present disclosure;
FIG. 4 illustrates a first exemplary embodiment of the BCI system of the present disclosure;
FIG. 5 illustrates a second exemplary embodiment of the BCI system of the present disclosure;
FIGs. 6A & 6B illustrate further exemplary embodiments of the BCI system of the present disclosure;
FIG 7 illustrates the main functional blocks in the method of operation of the BCI in accordance with the present disclosure.
FIG. 8 is block diagram showing a software architecture within which the present disclosure may be implemented, in accordance with some example embodiments; and
FIG. 9 is a diagrammatic representation of a machine, in the form of a computer system within which a set of instructions may be executed for causing the machine to perform any one or more of the methodologies discussed, in accordance with some example embodiments.

### DETAILED DESCRIPTION

The description that follows includes systems, methods, techniques, instruction sequences, and computing machine program products that embody illustrative embodiments of the disclosure. In the following description, for the purposes of explanation, numerous specific details are set forth in order to provide an understanding of various embodiments of the inventive subject matter. It will be evident, however, to those skilled in the art, that embodiments of the inventive subject matter may be practiced without these specific details. In general, well-known instruction instances, protocols, structures, and techniques are not necessarily shown in detail.

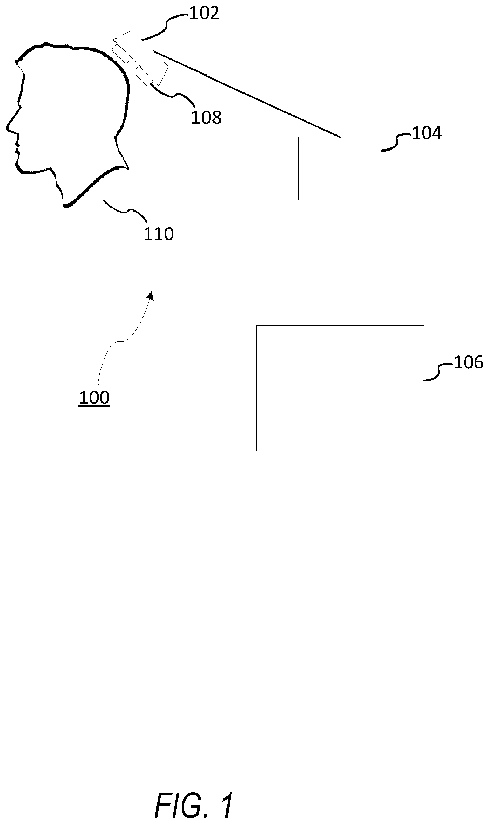

FIG. 1 illustrates an example of an electronic architecture for the reception and processing of EEG signals by means of an EEG device 100 according to the present disclosure.

To measure diffuse electric potentials on the surface of the skull of a subject 110, the EEG device 100 includes a portable device 102 (i.e. a cap or headpiece), analog-digital conversion (ADC) circuitry 104 and a microcontroller 106. The portable device 102 of FIG. 1 includes one or more electrodes 108, typically between 1 and 128 electrodes, advantageously between 2 and 64, advantageously between 4 and 16.

Each electrode 108 may comprise a sensor for detecting the electrical signals generated by the neuronal activity of the subject and an electronic circuit for pre-processing (e.g. filtering and/or amplifying) the detected signal before analog-digital conversion: such electrodes being termed "active". The active electrodes 108 are shown in use in FIG. 1, where the sensor is in physical proximity with the subject's scalp. The electrodes may be suitable for use with a conductive gel or other conductive liquid (termed "wet" electrodes) or without such liquids (i.e. "dry" electrodes).

Each ADC circuit 104 is configured to convert the signals of a given number of active electrodes 108, for example between 1 and 128.

The ADC circuits 104 are controlled by the microcontroller 106 and communicate with it for example by the protocol SPI ("Serial Peripheral Interface"). The microcontroller 106 packages the received data for transmission to an external processing unit (not shown), for example a computer, a mobile phone, a virtual reality headset, an automotive or aeronautical computer system, for example a car computer or a computer system, airplane, for example by Bluetooth, Wi-Fi ("Wireless Fidelity") or Li-Fi ("Light Fidelity").

In certain embodiments, each active electrode 108 is powered by a battery (not shown in FIG. 1). The battery is conveniently provided in a housing of the portable device 102.

In certain embodiments, each active electrode 108 measures a respective electric potential value from which the potential measured by a reference electrode (Ei = Vi - Vref) is subtracted, and this difference value is digitized by means of the ADC circuit 104 then transmitted by the microcontroller 106.

In certain embodiments, the method of the present disclosure introduces target objects for display in a graphical user interface of a display device. The target objects include control items and the control items are in turn associated with user-selectable actions.

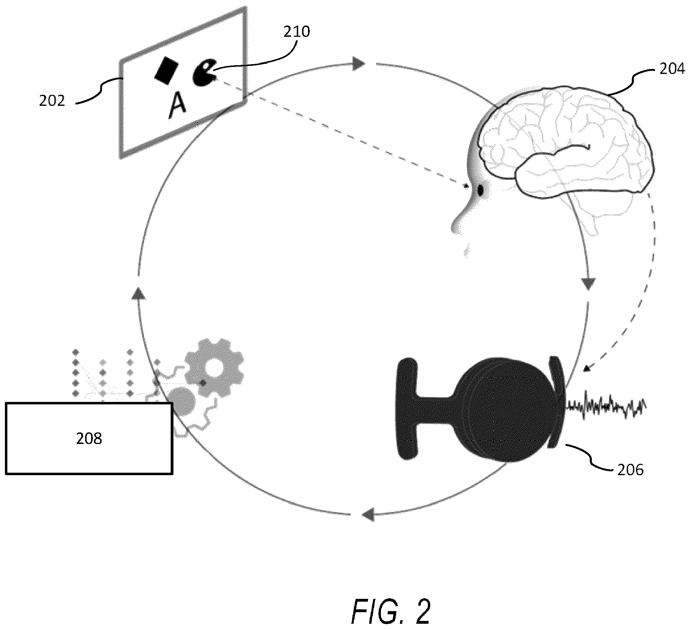

FIG. 2 illustrates a system incorporating a brain computer interface (BCI) according to the present disclosure. The system incorporates a neural response device 206, such as the EEG device 100 illustrated in FIG. 1. In the system, an image is displayed on a display of a display device 202. The subject 204 views the image on the display, focusing on a target object 210.

In an embodiment, the display device 202 displays at least the target object 210 as a graphical object with a varying temporal characteristic distinct from the temporal characteristic of other displayed objects and/or the background in the display. The varying temporal characteristic may be, for example, a constant or time-locked flickering effect altering the appearance of the target object at a rate greater than 6Hz. Where more than one graphical object is a potential target object (i.e. where the viewing subject is offered a choice of target object to focus attention on), each object is associated with a discrete spatial and/or temporal code.

The neural response device 206 detects neural responses (i.e. tiny electrical potentials indicative of brain activity in the visual cortex) associated with attention focused on the target object; the visual perception of the varying temporal characteristic of the target object(s) therefore acts as a stimulus in the subject's brain, generating a specific brain response that accords with the code associated with the target object in attention. The detected neural responses (e.g. electrical potentials) are then converted into digital signals and transferred to a processing device 208 for decoding. Examples of neural responses include visual evoked potentials (VEPs), which are commonly used in neuroscience research. The term VEPs encompasses conventional SSVEPs, as mentioned above, where stimuli oscillate at a specific frequency and other methods such as the code-modulated VEP, stimuli are subject to a variable or pseudo-random temporal code.

The processing device 208 executes instructions that interpret the received neural signals to determine feedback indicating the target object having the current focus of (visual) attention in real time. Decoding the information in the neural response signals relies upon a correspondence between that information and one or more aspect of the temporal profile of the target object (i.e. the stimulus). In certain embodiments, the processing device 208 and neural response device 206 may be provided in a single device so that decoding algorithms are executed directly on the detected neural responses. Thus, BCIs making use of visually associated neural signals can be used to determine which objects on a screen a user is focusing on.

In certain embodiments, the processing device may conveniently generate the image data presented on the display device 202 including the temporally varying target object.

The feedback may conveniently be presented visually on the display screen. For example, the display device may display an icon, cursor, crosshair or other graphical object or effect in close proximity to the target object, highlighting the object that appears to be the current focus of visual attention. Clearly, the visual display of such feedback has a reflexive cognitive effect on the perception of the target object, amplifying the brain response. This positive feedback (where the apparent target object is confirmed as the intended target object by virtue of prolonged amplified attention) is referred to herein as "neurosynchrony".

Research into the way in which the human visual sensing operates has shown that, when peering at a screen with multiple objects and focusing on one of those objects, the human visual system will be receptive to both high spatial frequencies (HSF) and low spatial frequencies (LSF). Evidence shows that the human visual system is primarily sensitive to the HSF components of the specific display area being focused on (e.g. the object the user is staring at). For peripheral objects, conversely, the human visual system is primarily sensitive to their LSF components. In other words, the neural signals picked up will essentially be impacted by both the HSF components from the target under focus and the LSF components from the peripheral targets. However, since all objects evoke some proportion of both HSF and LSF, processing the neural signals to determine the focus object can be impeded by the LSF noise contributed by peripheral objects. This tends to make identifying the object of focus less accurate and less timely.

As the human visual system is tuned to process parallel multiple stimuli at different locations of the visual field, typically unconsciously, peripheral object stimuli will continue triggering neural responses in the users' brains, even if they appear in the periphery of the visual field. As a result, this poses competition among multiple stimuli and renders the specific neural decoding of the object of focus (the target) more difficult.

Co-pending International patent application number PCT/EP2020/081348 filed on November 6th, 2020 (docket number 5380.002WO1), the entire specification of which is incorporated herein by reference, describes one approach to the challenge of determining the object of focus (the target) from the objects peripheral to the target (the distractors) with speed and accuracy. The approach described there relies upon the characteristics of the human visual system discussed above. A plurality of objects is displayed in such a way that each one is separated into a version composed only of the LSF components of the object and a version composed of only HSF components. In one example, the blinking visual stimulus used to elicit a decodable neural response (e.g. SSVEPs) is conveyed only through the HSF version of the object. This blinking HSF version is superimposed on the LSF version (which does not blink).

Known systems in the medical or related research fields generally include a head-mounted device with attachment locations for receiving individual sensors/electrodes. Electronic circuits are then connected to the electrodes and to the housing of an acquisition chain (i.e. an assembly of connected components used in acquiring the EEG signals). The EEG device is thus typically formed of three distinct elements that the operator / exhibitor must assemble at each use. Again, the nature of the EEG device is such that technical assistance is desirable, if not essential.

The BCI described above may be used in conjunction with real world objects, rendering the objects controllable or otherwise subject to interaction. In certain embodiments, the generation of stimuli is handled by one or more light source (such as a light emitting diode, LED, or a small display unit) provided in association with (or even, on the surface of) the controllable object.

In certain embodiments, the generation of stimuli is handled by a projector or a scanning laser device so that visual stimuli are projected onto the controllable object and the controllable object outputs a visual stimulus by reflecting a projected stimulus.

As was the case in the BCI using a display screen through which the user interacts with on-screen objects, the controllable objects in the present disclosure can themselves be made to exhibit visual stimuli with characteristic modulations (e.g. blinking stimuli) so that the neural response to the presence of those stimuli become evident and decodable from neural signals captured by a neural signal capture device (such as an EEG device).

In certain embodiments, the determination of focus of attention upon a visual display of a controllable device is used to address a command to that controllable object. The controllable object may then implement an action based on said command: for example, the controllable object may emit an audible sound, unlock a door, switch on or off, change an operational state, etc. The action may also provide the user with visual or other feedback associated with the controllable object: this may be used in the positive feedback loop discussed above but may also provide a real-time feedback indicating the degree of certainty with which the object is identified as the focus of attention, to give the user a about his concentration level.

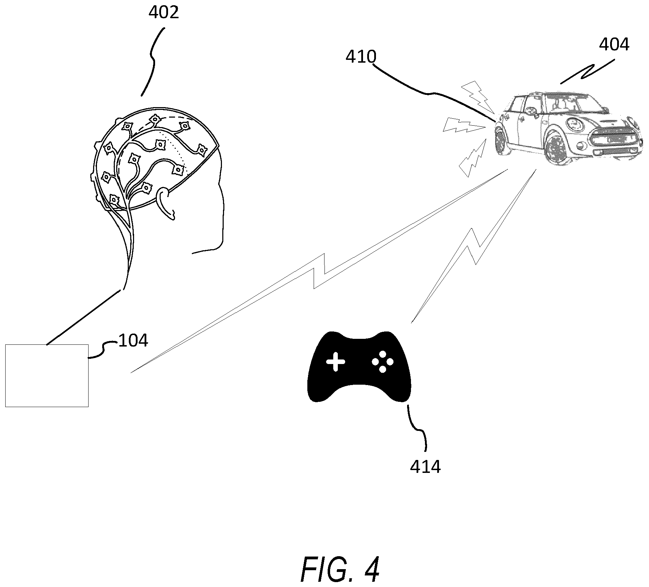

FIG. 4 shows a first exemplary embodiment in which at least one surface of a remote-controlled, RC, car 404 incorporates an LED array 410 capable of generating a visual display. In one embodiment, the RC car comprises: a reception circuit that picks up commands sent from a stimulus generator (this can conveniently be the decoding computer 104, as illustrated), through a wireless one way communication means (such as radio frequency, RF; infrared; or near-field communication, NFC); a processing unit (i.e. a microcontroller) whose role is to interpret the received commands and to control the operation of the RC car and/or the visual display accordingly; and a display driving circuit that applies the light modulation to the type of display device being used to generate the visual display (LED panel 410, here). The RC car 404 may further be configured to receive commands from a conventional radio controller 414 over a radio communication link 412. Thus, the operation of the RC car may be controlled through commands originating in the decoding computer 104 (as a result of decoded brain activity in the user 402) and the radio controller 414. In certain embodiments, the stimulus generator is embedded, along with the visual display, in the RC car 404. Commands from the decoding computer 104 may include signals to synchronize or configure the modulation generated by the stimulus generator with the decoding computer. This link between decoding computer and the object can be omitted if it is assumed that brain activity is monitored using SSVEPs at a pre-determined set frequency. The microcontroller may be programmed to modulate light at that same frequency, in an asynchronous matter, so that the modulation need not be sent or even synchronized with the decoding computer 104.

The visual display (i.e. LED array 410) emits a visual stimulus that includes a temporal modulation (i.e. a blinking effect) unique to a given RC car 404. By visually attending to that car (and consequently the stimulus output by that car), the user induces a neural response that can in turn be captured by a BCI (such as that described above). The neural signals captured from the user's brain encode the temporal modulation. The BCI then decodes the neural signals to determine which car (if any) is the object of the user's attention (or focus). In certain embodiments, the BCI includes a communication unit through which a command may be transmitted to the remote-controlled car. This command may be, for instance, an instruction to enter an active state, whereupon control signals transmitted by a conventional remote controller device may be transmitted to the car. The command may conveniently be a "stay alive" command, whereby continued attention leads to repeated transmission of the command but diverted attention leads the car to deactivate. Where more than one such remote controlled car (each generating a different stimulus) is present, the user may change focus (the car without attention reverting to a standby or inactive state) and apply the remote controller to the car forming the new focus of attention.

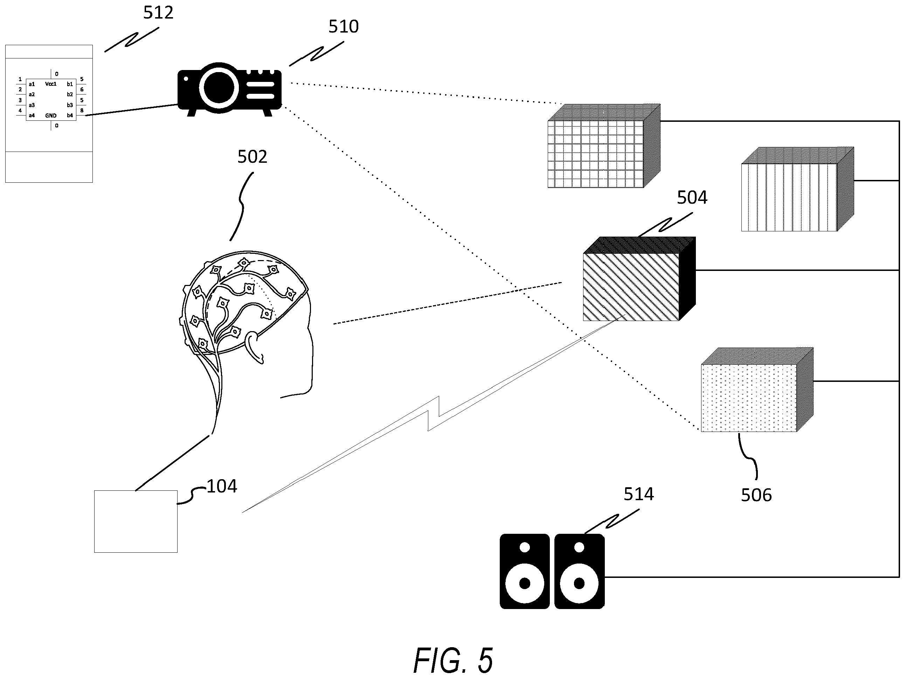

FIG. 5 shows a second exemplary embodiment in which a projector 510 is used to project a stimulus that includes a temporal modulation (i.e. a blinking effect) onto at least one surface of a real world object 504 associated with a controllable object 514, the stimulus being generated by a stimulus generator 512. When a BCI-equipped user 502 views light reflected from the object 504, that reflected light induces a decodable neural response in the brain of the user (that may be captured by the BCI). FIG. 5 shows a plurality of real world objects 504, 506, etc - the projector 510 projecting a respective stimulus on each object. The BCI then decodes the neural signals to determine which of the objects (if any) is the object of the user's attention. Each real world object 504, 506, etc. is associated with a respective command or interaction with the associated controllable object 514. In certain embodiments, the BCI includes a communication unit through which a command may be transmitted to the controllable object identified as the object of attention. This command may be, for instance, an instruction to enter an active state. In one embodiment, as illustrated, the controllable object includes a loudspeaker 514 and the command may be a command to control the loudspeaker to reproduce an audio signal, such as an alarm or a musical tone. In certain embodiments, the or each real world object upon which a stimulus is projected may itself be a controllable object.

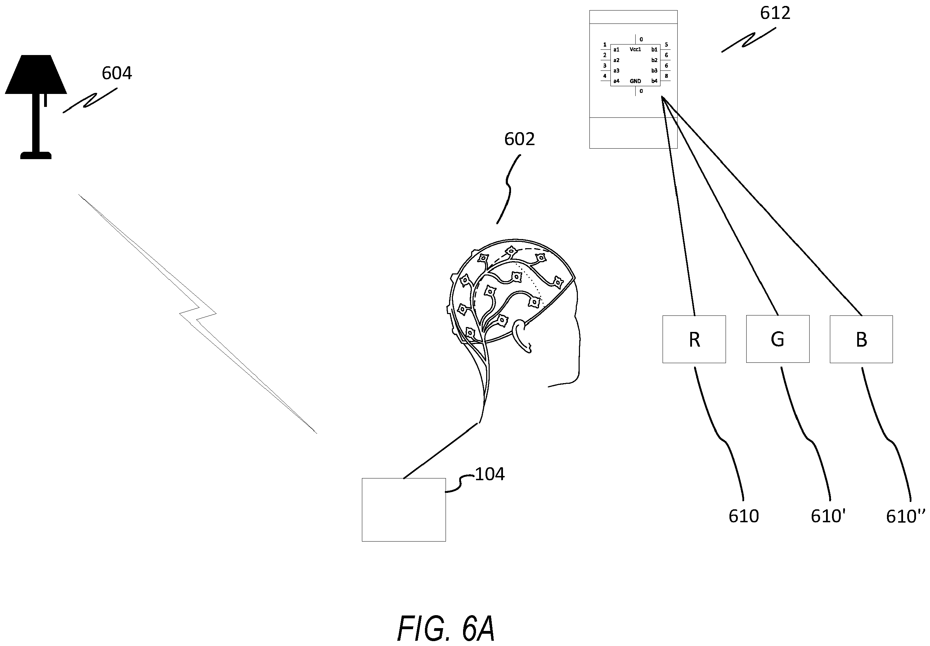

FIG. 6A shows a further exemplary embodiment in which three visual displays 610, 610', 610" are provided remotely from a controllable object 604. Each of the visual displays 610, 610', 610", e.g. respective LED arrays, generates a corresponding, different visual stimulus that includes a temporal modulation (i.e. a blinking effect). The visual stimuli used here take advantage of the high decodability of HSF elements such as multiple tiny dashes (by using opaque physical masks over the LED arrays, the mask may be considered as a type of printed gabor filter). In certain embodiments, the masks themselves are controllable: a controllable motor may toggle a shutter arrangement between a closed and open state, alternatively a transparent liquid crystal device may be used to mask or transmit incident light from one or more light sources controllably, providing a backlit LCD display with a controllable temporally and/or spatially variable mask.

In the illustrated example, the respective visual displays 610, 610', 610" incorporate a sign or icon indicating a selectable option (here, a color: red, R; green, G; blue, B). The sign or icon may be formed by providing an engraved pattern in an otherwise opaque physical mask or by controlling the pattern of light transmitted by a shutter arrangement or LCD. By focusing attention on one of the visual displays 610, 610', 610", a BCI-equipped user 602 induces a neural response that corresponds to the visual stimulus unique to that visual display 610. This is then interpreted as an intention to select the corresponding option, red, R say. The intended option is then used by the processor 104 of the BCI, say, to generate a command that is transmitted to the controllable object 604. In the illustrated example, the controllable object is a color-tunable lamp 604 and the command may be an instruction to control the lamp to emit red light. As for the RC car example in FIG. 4, the circuitry used at each of the visual displays 610, 610', 610" in the FIG. 6A example includes: a reception circuit that picks up commands sent from a stimulus generator 612; a processing unit; and a display driving circuit. While illustrated as a wireless link in FIG. 6A, the communication link between the processor 104 of the BCI (i.e. the decoding computer) and object 604 may also be wired.

In certain embodiments, the respective visual displays 610, 610', 610" may display visual stimuli that are associated with respective commands to be sent to corresponding, different controllable objects. Thus, there may be a plurality of different lamps each subject to a command associated with a respective one of the displayed visual stimuli. Rather than simply control the colour of light emitted by one tunable lamp, attention to one visual stimulus may for example activate one or more of the lamps; attention to another visual stimulus (displayed on another of the displays) may for example dim one or more of the lamps; and attention to a third visual stimulus (displayed on yet another of the displays) may cause the plurality of different lamps to enter an economy mode, where the lamps are only to be lit in the absence of sufficient natural light.

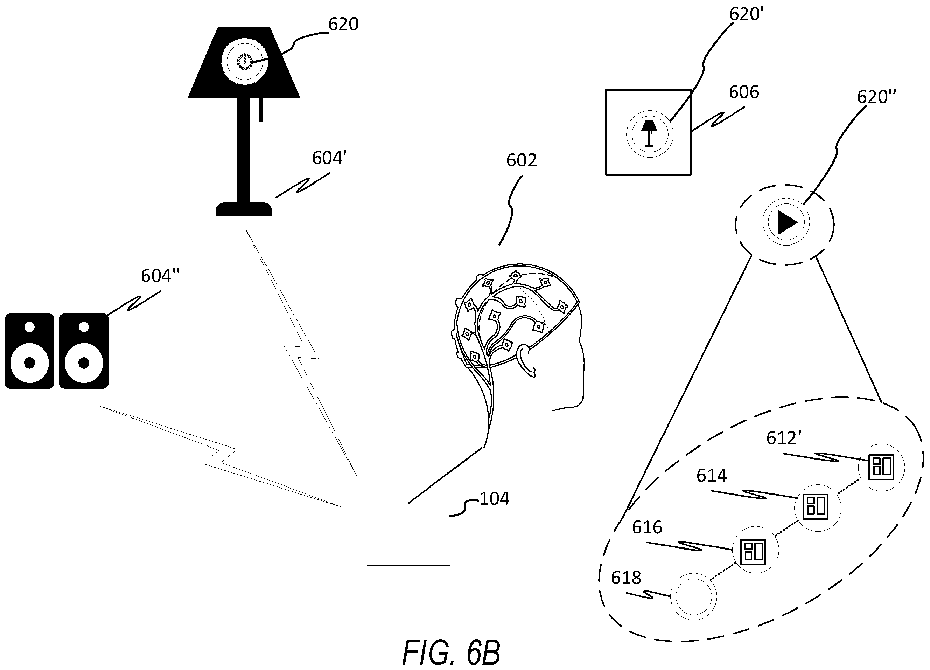

In another exemplary embodiment illustrated in FIG. 6B, visual displays, referred to as "electronic badges", take the form of physical, moveable objects, separate from real world controllable objects but logically associated with at least one of them. In the present disclosure, these electronic badges provide a small, moveable, programmable screen (e.g. 3cm by 3cm) that display one or more visual stimuli that have an association with other (controllable) objects or specific functions of such objects. The screen may, for instance, be a backlit LCD, an OLED or AMOLED display. The screen may be programmable to emit light with a temporal modulation similar to the light sources above, thereby generating one or more visual stimulus. Unlike the visual displays of FIG. 6A, the electronic badges 620, 620', 620" of FIG. 6B each include a stimulus generator 612' of their own, in addition to a processing unit 614, a display driving circuit 616 and the screen 618 for outputting the visual stimulus (see inset 'exploded' view of badge 620").

An electronic badge may be embedded within a physical object (which may be a controllable object associated with the or each stimulus generated by the electronic badge): badge 620 is embedded in controllable lamp 604'. Alternatively the badge may be placed on, or affixed (temporarily or permanently) to, the surface of a physical object or indeed to any surface from which interaction with, or control of, a controllable physical object might be convenient, such as a nearby wall, control panel, or item of furniture. In FIG. 6B, the controllable lamp 604' may also be controlled through interaction with electronic badge 620' in control panel 606. In other embodiments, the electronic badge 620" may be portable, or even wearable. In certain embodiments, the electronic badge includes a battery and a wireless communication module. The electronic badges may be attached to surfaces in any conventional manner, such as clips, adhesive, magnets, screws, bolts or any other such fixing means.

In certain cases, as in FIG 6B, more than one electronic badge may be used to control different types of interaction with a single physical object: each electronic badge displaying a different visual stimulus and a different action being associated with each stimulus. The controllable lamp 604' may be switched on through badge 620 and dimmed through badge 620'. In a further illustration, consider a case where instead of the three masked visual displays of FIG. 6A, three electronic badges may be arranged (on a nearby desktop, say) to display visual stimuli that differ in terms of their respective modulations, each badge having different associated command for the colour-tunable lamp 604. The respective badges may also be controlled to differ in their visual appearance, glowing in colours that represent the effect required from the color-tunable lamp, for example.

In certain cases, visual stimuli displayed on the screen of the electronic badge may be applied to the entire screen or to respective portions of the screen according to the programming of the badge. As previously described, the visual stimuli are generated to evoke a decodable neural response in the brain of the user of a BCI attending to that stimulus. The visual stimuli may appear as multiple tiny dashes or 'beans' to which the modulations are applied (reducing the blinking effect without impairing the facility for evoking a neural response when a given stimulus is the focus of a BCI user's attention). The neural response may in turn be measured and decoded to determine which electronic badge is the focus of the user's attention and, since the badge is logically associated with the real world object and/or with a control action for the real world object, thereby to determine that the real world object is the object of interest and/or control.

In certain cases, each badge or each of a plurality of portions of a badge may display respective symbols that correspond to associated actions/commands (such as on/off, play/pause, forward, etc.) governing the operation of one or more controllable real world objects. Different visual stimuli may then be applied to the respective symbols. In certain embodiments, the symbols displayed may be changed according to the programming of the badge. For example, badge 620" showing a "play" symbol may replace the play symbol with a "pause" symbol" when a controlled audio system 604" is in a playback state, for example. Similarly, in a badge affixed to a controllable door, attention to the stimulus displayed on the badge may be interpreted as an "open" command or a "close" command according to the current state of the door.

The controllable real-world objects to which the light emitting unit applies visual stimuli are not limited to the objects mentioned in the examples above. In addition to controllable doors, lamps, remote controlled toys, audio systems/loudspeakers, the same touch-free control may be granted over the operation of switches and valves more generally. Users unable to manipulate controllable devices by hand may still control their operation: from operating a faucet to provide water in a basin to selecting an item to be retrieved, by robot, from a shelf in a warehouse. Aspects of the present disclosure may be applied in many different settings including domestic, healthcare, commercial (retail, wholesale and logistical), agricultural and maritime.

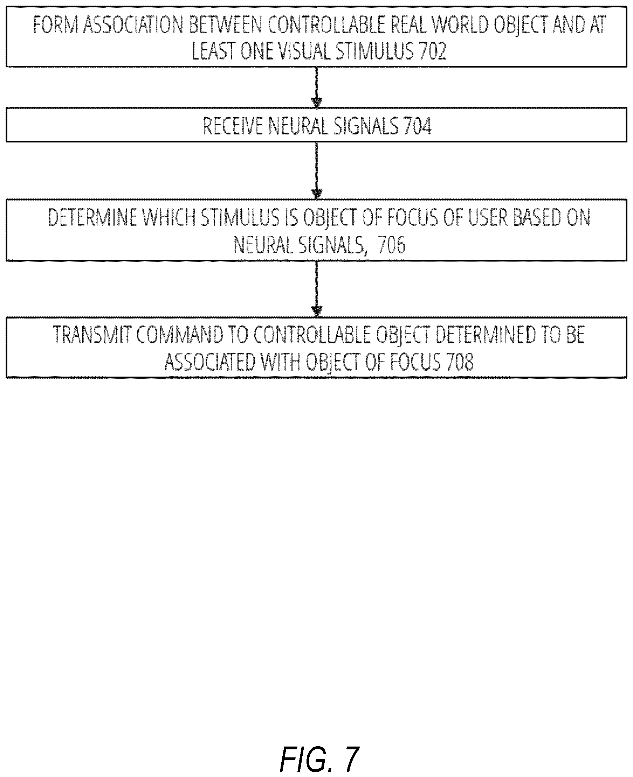

FIG. 7 illustrates the main functional blocks in the method of operation of a BCI system (for example, the BCI system illustrated in FIG. 2) in accordance with the present disclosure. In block 702, the interface device 208 forms an association between a controllable real world object and the at least one visual stimulus. In block 704, the interface device 208 receives neural signals associated with a user captured by the neural signal capture device 206. In block 706, the interface device 208 determines which of the at least one visual stimuli is an object of focus of the user based on the neural signals, the object of focus being inferred from the presence in the neural signals of a component having a property associated with the characteristic modulation of the visual stimulus. In block 708, the interface device 208 transmits a command to the controllable object determined to be associated with the object of focus, thereby controlling the controllable object to implement an action based on the command.

The positive neurosynchrony feedback loop described in relation to the BCI in FIG. 2 may be employed to confirm the intent of the user, for example to initiate an action such as an information request, the toggling of control states of real-world objects, the activation/selection of objects (e.g., for control) in mixed reality settings.

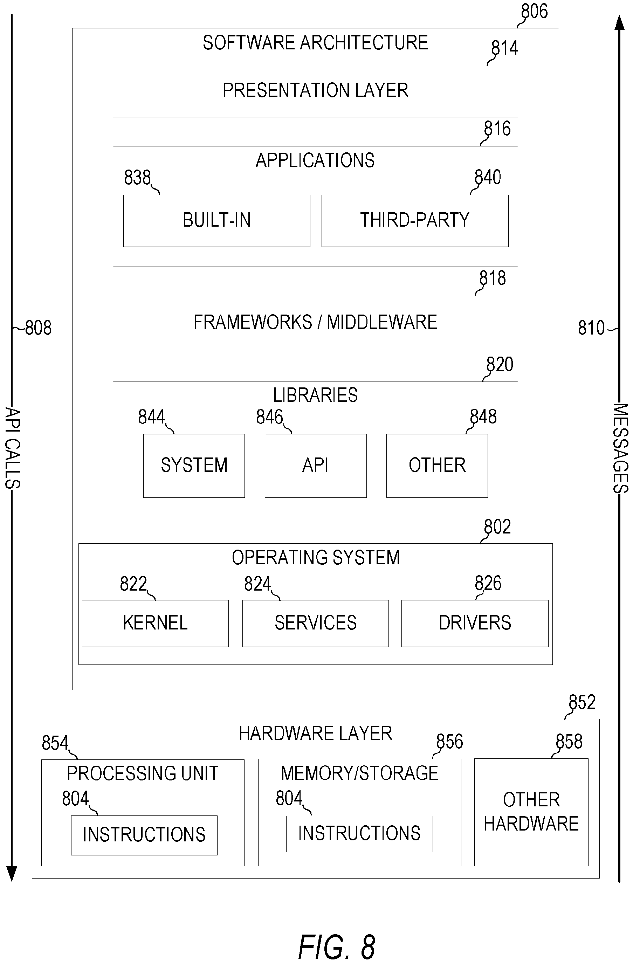

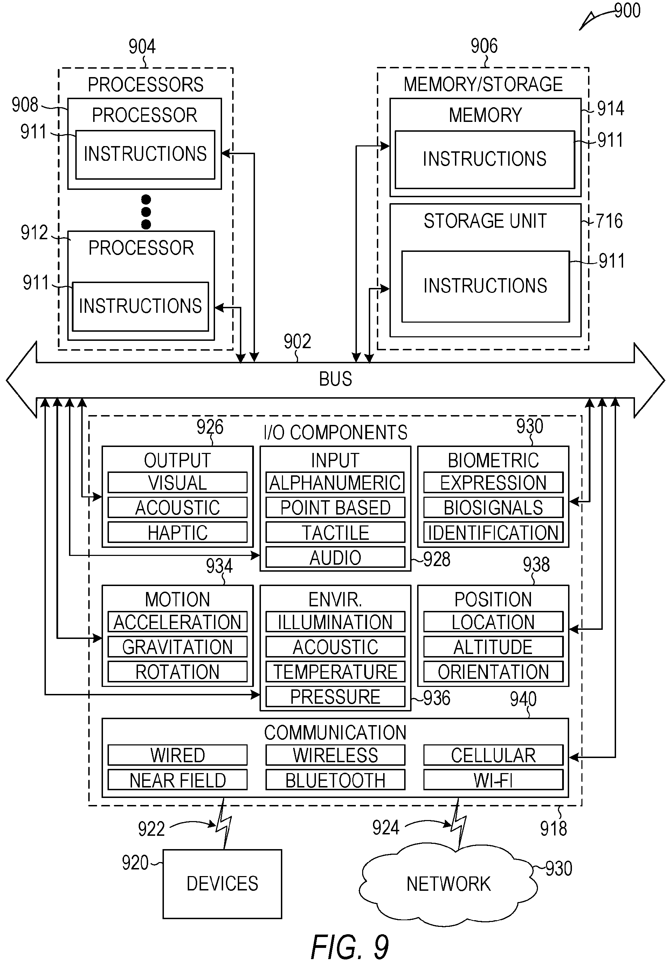

FIG. 8 is a block diagram illustrating an example software architecture 806, which may be used in conjunction with various hardware architectures herein described, such as the processing device 208 of FIG. 2. FIG. 8 is a non-limiting example of a software architecture and it will be appreciated that many other architectures may be implemented to facilitate the functionality described herein. The software architecture 806 may execute on hardware such as the processing device 208 of FIG. 2 or the machine 900 of FIG. 9 that includes, among other things, processors 904, memory 906, and input/output (I/O) components 918. A representative hardware layer 852 is illustrated and can represent, for example, the machine 900 of FIG. 9. The representative hardware layer 852 includes a processing unit 854 having associated executable instructions 804. The executable instructions 804 represent the executable instructions of the software architecture 806, including implementation of the methods, modules and so forth described herein. The hardware layer 852 also includes memory and/or storage modules shown as memory/storage 856, which also have the executable instructions 804. The hardware layer 852 may also comprise other hardware 858, for example dedicated hardware for interfacing with EEG electrodes and/or for interfacing with display devices.

In the example architecture of FIG. 8, the software architecture 806 may be conceptualized as a stack of layers where each layer provides particular functionality. For example, the software architecture 806 may include layers such as an operating system 802, libraries 820, frameworks or middleware 818, applications 816 and a presentation layer 814. Operationally, the applications 816 and/or other components within the layers may invoke application programming interface (API) calls 808 through the software stack and receive a response as messages 810. The layers illustrated are representative in nature and not all software architectures have all layers. For example, some mobile or special purpose operating systems may not provide the frameworks/middleware 818, while others may provide such a layer. Other software architectures may include additional or different layers.

The operating system 802 may manage hardware resources and provide common services. The operating system 802 may include, for example, a kernel 822, services 824, and drivers 826. The kernel 822 may act as an abstraction layer between the hardware and the other software layers. For example, the kernel 822 may be responsible for memory management, processor management (e.g., scheduling), component management, networking, security settings, and so on. The services 824 may provide other common services for the other software layers. The drivers 826 may be responsible for controlling or interfacing with the underlying hardware. For instance, the drivers 826 may include display drivers, EEG device drivers, camera drivers, Bluetooth^{®} drivers, flash memory drivers, serial communication drivers (e.g., Universal Serial Bus (USB) drivers), Wi-Fi^{®} drivers, audio drivers, power management drivers, and so forth depending on the hardware configuration.

The libraries 820 may provide a common infrastructure that may be used by the applications 816 and/or other components and/or layers. The libraries 820 typically provide functionality that allows other software modules to perform tasks in an easier fashion than by interfacing directly with the underlying operating system 802 functionality (e.g., kernel 822, services 824, and/or drivers 826). The libraries 820 may include system libraries 844 (e.g., C standard library) that may provide functions such as memory allocation functions, string manipulation functions, mathematic functions, and the like. In addition, the libraries 820 may include API libraries 846 such as media libraries (e.g., libraries to support presentation and manipulation of various media formats such as MPEG4, H.264, MP3, AAC, AMR, JPG, and PNG), graphics libraries (e.g., an OpenGL framework that may be used to render 2D and 3D graphic content on a display), database libraries (e.g., SQLite that may provide various relational database functions), web libraries (e.g., WebKit that may provide web browsing functionality), and the like. The libraries 820 may also include a wide variety of other libraries 848 to provide many other APIs to the applications 816 and other software components/modules.

The frameworks 818 (also sometimes referred to as middleware) provide a higher-level common infrastructure that may be used by the applications 816 and/or other software components/modules. For example, the frameworks/middleware 818 may provide various graphic user interface (GUI) functions, high-level resource management, high-level location services, and so forth. The frameworks/middleware 818 may provide a broad spectrum of other APIs that may be used by the applications 816 and/or other software components/modules, some of which may be specific to a particular operating system or platform.

The applications 816 include built-in applications 838 and/or third-party applications 840.

The applications 816 may use built-in operating system functions (e.g., kernel 822, services 824, and/or drivers 826), libraries 820, or frameworks/middleware 818 to create user interfaces to interact with users of the system. Alternatively, or additionally, in some systems interactions with a user may occur through a presentation layer, such as the presentation layer 814. In these systems, the application/module "logic" can be separated from the aspects of the application/module that interact with a user.

FIG. 9 is a block diagram illustrating components of a machine 900 (such as the processing device 208 of FIG. 2), according to some example embodiments, able to read instructions from a machine-readable medium (e.g., a machine-readable storage medium) and perform any one or more of the methodologies discussed herein. Specifically, FIG. 9 shows a diagrammatic representation of the machine 900 in the example form of a computer system, within which instructions 911 (e.g., software, a program, an application, an applet, an app, or other executable code) for causing the machine 900 to perform any one or more of the methodologies discussed herein may be executed. As such, the instructions 911 may be used to implement modules or components described herein. The instructions 911 transform the general, non-programmed machine 900 into a particular machine programmed to carry out the described and illustrated functions in the manner described. In alternative embodiments, the machine 900 operates as a standalone device or may be coupled (e.g., networked) to other machines. In a networked deployment, the machine 900 may operate in the capacity of a server machine or a client machine in a server-client network environment, or as a peer machine in a peer-to-peer (or distributed) network environment. The machine 900 may comprise, but not be limited to, a server computer, a client computer, a personal computer (PC), a tablet computer, a laptop computer, a netbook, a set-top box (STB), a personal digital assistant (PDA), an entertainment media system, a cellular telephone, a smart phone, a mobile device, a wearable device (e.g., a smart watch, or head mounted display), a smart home device (e.g., a smart appliance), other smart devices, a web appliance, a network router, a network switch, a network bridge, or any machine capable of executing the instructions 911, sequentially or otherwise, that specify actions to be taken by the machine 900. Further, while only a single machine 900 is illustrated, the term "machine" shall also be taken to include a collection of machines that individually or jointly execute the instructions 911 to perform any one or more of the methodologies discussed herein.

The machine 900 may include processors 904, memory 906, and input/output (I/O) components 918, which may be configured to communicate with each other such as via a bus 902. In an example embodiment, the processors 904 (e.g., a Central Processing Unit (CPU), a Reduced Instruction Set Computing (RISC) processor, a Complex Instruction Set Computing (CISC) processor, a Graphics Processing Unit (GPU), a Digital Signal Processor (DSP), an Application Specific Integrated Circuit (ASIC), a Radio-Frequency Integrated Circuit (RFIC), another processor, or any suitable combination thereof) may include, for example, a processor 908 and a processor 912 that may execute the instructions 911. The term "processor" is intended to include multi-core processor that may comprise two or more independent processors (sometimes referred to as "cores") that may execute instructions contemporaneously. Although FIG. 9 shows multiple processors, the machine 900 may include a single processor with a single core, a single processor with multiple cores (e.g., a multi-core processor), multiple processors with a single core, multiple processors with multiples cores, or any combination thereof.

The memory 906 may include a memory 914, such as a main memory, a static memory, or other memory storage, and a storage unit 916, both accessible to the processors 904 such as via the bus 902. The storage unit 916 and memory 914 store the instructions 911 embodying any one or more of the methodologies or functions described herein. The instructions 911 may also reside, completely or partially, within the memory 914, within the storage unit 916, within at least one of the processors 904 (e.g., within the processor's cache memory), or any suitable combination thereof, during execution thereof by the machine 900. Accordingly, the memory 914, the storage unit 916, and the memory of processors 904 are examples of machine-readable media.

As used herein, "machine-readable medium" means a device able to store instructions and data temporarily or permanently and may include, but is not limited to, random-access memory (RAM), read-only memory (ROM), buffer memory, flash memory, optical media, magnetic media, cache memory, other types of storage (e.g., Erasable Programmable Read-Only Memory (EEPROM)), and/or any suitable combination thereof. The term "machine-readable medium" should be taken to include a single medium or multiple media (e.g., a centralized or distributed database, or associated caches and servers) able to store the instructions 911. The term "machine-readable medium" shall also be taken to include any medium, or combination of multiple media, that is capable of storing instructions (e.g., instructions 911) for execution by a machine (e.g., machine 900), such that the instructions, when executed by one or more processors of the machine 900 (e.g., processors 904), cause the machine 900 to perform any one or more of the methodologies described herein. Accordingly, a "machine-readable medium" refers to a single storage apparatus or device, as well as "cloud-based" storage systems or storage networks that include multiple storage apparatus or devices. The term "machine-readable medium" excludes signals per se.

The input/output (I/O) components 918 may include a wide variety of components to receive input, provide output, produce output, transmit information, exchange information, capture measurements, and so on. The specific input/output (I/O) components 918 that are included in a particular machine will depend on the type of machine. For example, user interface machines and portable machines such as mobile phones will likely include a touch input device or other such input mechanisms, while a headless server machine will likely not include such a touch input device. It will be appreciated that the input/output (I/O) components 918 may include many other components that are not shown in FIG. 9.

The input/output (I/O) components 918 are grouped according to functionality merely for simplifying the following discussion and the grouping is in no way limiting. In various example embodiments, the input/output (I/O) components 918 may include output components 926 and input components 928. The output components 926 may include visual components (e.g., a display such as a plasma display panel (PDP), a light emitting diode (LED) display, a liquid crystal display (LCD), a projector, or a cathode ray tube (CRT)), acoustic components (e.g., speakers), haptic components (e.g., a vibratory motor, resistance mechanisms), other signal generators, and so forth. The input components 928 may include alphanumeric input components (e.g., a keyboard, a touch screen configured to receive alphanumeric input, a photo-optical keyboard, or other alphanumeric input components), point-based input components (e.g., a mouse, a touchpad, a trackball, a joystick, a motion sensor, or other pointing instruments), tactile input components (e.g., a physical button, a touch screen that provides location and/or force of touches or touch gestures, or other tactile input components), audio input components (e.g., a microphone), and the like.

In further example embodiments, the input/output (I/O) components 918 may include biometric components 930, motion components 934, environment components 936, or position components 938 among a wide array of other components. For example, the biometric components 930 may include components to detect expressions (e.g., hand expressions, facial expressions, vocal expressions, body gestures, or eye tracking), measure biosignals (e.g., blood pressure, heart rate, body temperature, perspiration, or brain waves, such as the output from an EEG device), identify a person (e.g., voice identification, retinal identification, facial identification, fingerprint identification, or electroencephalogram based identification), and the like. The motion components 934 may include acceleration sensor components (e.g., accelerometer), gravitation sensor components, rotation sensor components (e.g., gyroscope), and so forth. The environmental environment components 936 may include, for example, illumination sensor components (e.g., photometer), temperature sensor components (e.g., one or more thermometers that detect ambient temperature), humidity sensor components, pressure sensor components (e.g., barometer), acoustic sensor components (e.g., one or more microphones that detect background noise), proximity sensor components (e.g., infrared sensors that detect nearby objects), gas sensors (e.g., gas detection sensors to detect concentrations of hazardous gases for safety or to measure pollutants in the atmosphere), or other components that may provide indications, measurements, or signals corresponding to a surrounding physical environment. The position components 938 may include location sensor components (e.g., a Global Position System (GPS) receiver component), altitude sensor components (e.g., altimeters or barometers that detect air pressure from which altitude may be derived), orientation sensor components (e.g., magnetometers), and the like.

Communication may be implemented using a wide variety of technologies. The input/output (I/O) components 918 may include communication components 940 operable to couple the machine 900 to a network 932 or devices 920 via a coupling 924 and a coupling 922 respectively. For example, the communication components 940 may include a network interface component or other suitable device to interface with the network 932. In further examples, communication components 940 may include wired communication components, wireless communication components, cellular communication components, Near Field Communication (NFC) components, Bluetooth^{®} components (e.g., Bluetooth^{®} Low Energy), Wi-Fi^{®} components, and other communication components to provide communication via other modalities. The devices 920 may be another machine or any of a wide variety of peripheral devices (e.g., a peripheral device coupled via a Universal Serial Bus (USB)). Where an EEG device or display device is not integral with the machine 900, the device 920 may be an EEG device (such as neural response device 206) and/or a display device (such as display device of FIGS 2 and 3).

Although described through a number of detailed exemplary embodiments, the portable devices for the acquisition of electroencephalographic signals according to the present disclosure comprise various variants, modifications and improvements which will be obvious to those skilled in the art, it being understood that these various variants, modifications and improvements fall within the scope of the subject of the present disclosure, as defined by the following claims.

Although an overview of the inventive subject matter has been described with reference to specific example embodiments, various modifications and changes may be made to these embodiments without departing from the broader scope of embodiments of the present disclosure. Such embodiments of the inventive subject matter may be referred to herein, individually or collectively, by the term "invention" merely for convenience and without intending to voluntarily limit the scope of this application to any single disclosure or inventive concept if more than one is, in fact, disclosed.

The embodiments illustrated herein are described in sufficient detail to enable those skilled in the art to practice the teachings disclosed. Other embodiments may be used and derived therefrom, such that structural and logical substitutions and changes may be made without departing from the scope of this disclosure. The Detailed Description, therefore, is not to be taken in a limiting sense, and the scope of various embodiments is defined only by the appended claims, along with the full range of equivalents to which such claims are entitled.

As used herein, the term "or" may be construed in either an inclusive or exclusive sense. Moreover, plural instances may be provided for resources, operations, or structures described herein as a single instance. Additionally, boundaries between various resources, operations, modules, engines, and data stores are somewhat arbitrary, and particular operations are illustrated in a context of specific illustrative configurations. Other allocations of functionality are envisioned and may fall within a scope of various embodiments of the present disclosure. In general, structures and functionality presented as separate resources in the example configurations may be implemented as a combined structure or resource. Similarly, structures and functionality presented as a single resource may be implemented as separate resources. These and other variations, modifications, additions, and improvements fall within a scope of embodiments of the present disclosure as represented by the appended claims. The specification and drawings are, accordingly, to be regarded in an illustrative rather than a restrictive sense.

Thus, the present disclosure describes a system and method for improving the accuracy, speed performance and visual comfort of BCIs.

### EXAMPLES

To better illustrate the system and methods disclosed herein, a non-limiting list of examples is provided here:
1. A brain computer interface system, comprising:
   at least one light emitting unit outputting a respective visual stimulus generated by a stimulus generator, the visual stimulus having a characteristic modulation;
   at least one controllable object configured to receive user instructions, each controllable object being associated with at least one visual stimulus;
   a neural signal capture device configured to capture neural signals associated with the user;
   an interfacing device operatively coupled to the neural signal capture device and the controllable object, the interfacing device including:
      a memory; and
      a processor operatively coupled to the memory and configured to:
         receive the neural signals from the neural signal capture device;
         determine which of the at least one visual stimuli is an object of focus of the user based on the neural signals, the object of focus being inferred from the presence in the neural signals of a component having a property associated with the characteristic modulation of the visual stimulus; and
         transmitting a command to the controllable object determined to be associated with the object of focus,
   wherein said controllable object implements an action based on said command.
2. The brain computer interface system of example 1, wherein implementing the action comprises controlling the controllable object to change state from a standby state.
3. The brain computer interface system of example 1 or 2, wherein the at least one controllable object includes the stimulus generator and the light emitting unit for outputting the visual stimulus generated by the stimulus generator.
4. The brain computer interface system of example 1 or example 2, wherein the stimulus generator and the light emitting unit are provided in an electronic badge, the electronic badge being separate from, but logically associated with, the at least one controllable object.
5. The brain computer interface system of example 1 or example 2, wherein the light emitting unit is a projector, the projector being operatively coupled to the stimulus generator and projecting the respective visual stimulus onto the controllable object; and
   wherein the controllable object reflects the projected stimulus.
6. The brain computer interface system of any one of examples 1 to 5, wherein the or each light emitting unit comprises at least one of: a single light emitting diode (LED); an array of LEDs; a liquid crystal display (LCD) device; an organic light-emitting diode (OLED) display; or an electric arc.
7. The brain computer interface system of any one of examples 1 to 6, further comprising a processing device, the processing device including the stimulus generator, wherein the processing device is communicatively coupled with the interfacing device, the processing device configured to communicate information indicating the generated visual stimulus to the interfacing device.
8. The brain computer interface system of any one of examples 1 to 7, wherein the modulation is selectively applied to the high spatial frequency (HSF) component of the display data.
9. A method of operation of a brain computer interface system, the brain computer interface system including a neural signal capture device and at least one light emitting unit for outputting a visual stimulus generated by a stimulus generator, the visual stimulus having a characteristic modulation,
   wherein the method comprises, in a hardware interfacing device operatively coupled to the neural signal capture device and a controllable real world object:
   forming an association between the controllable real world object and the at least one visual stimulus;
   receiving neural signals associated with a user captured by the neural signal capture device;
   determining which of the at least one visual stimuli is an object of focus of the user based on the neural signals, the object of focus being inferred from the presence in the neural signals of a component having a property associated with the characteristic modulation of the visual stimulus; and
   transmitting a command to the controllable object determined to be associated with the object of focus, thereby controlling said controllable object to implement an action based on said command.
10. The method of example 9, wherein implementing the action comprises controlling the controllable object to change state from a standby state.
11. The method of example 9 or example 10, wherein the at least one controllable object includes the stimulus generator and the light emitting unit, and wherein forming the association between the controllable real world object and the at least one visual stimulus includes controlling the light emitting unit to output the visual stimulus generated by the stimulus generator.
12. The method of example 9 or example 10, wherein the stimulus generator and the light emitting unit are provided in an electronic badge, the electronic badge being separate from the at least one controllable object, and wherein forming the association between the controllable real world object and the at least one visual stimulus includes logically associating the electronic badge with the at least one controllable object and controlling the light emitting unit of the electronic badge to output the visual stimulus generated by the stimulus generator.
13. The method of example 9 or example 10, wherein the light emitting unit is a projector, the projector being operatively coupled to the stimulus generator. and wherein forming the association between the controllable real world object and the at least one visual stimulus includes controlling the projector to project the respective visual stimulus onto the controllable object, so that the controllable object reflects the projected stimulus.
14. The method of any one of examples 9 to 13, wherein the brain computer interface system further comprises a processing device, the processing device including the stimulus generator; wherein the processing device is communicatively coupled with the hardware interfacing device, and wherein forming the association between the controllable real world object and the at least one visual stimulus further comprises, causing the processing device to communicate information indicating the generated visual stimulus to the interfacing device.
15. The method of any one of examples 9 to 14, wherein the modulation is selectively applied to the high spatial frequency (HSF) component of the display data.
16. A computer-readable storage medium, the computer-readable storage medium carrying instructions that when executed by a machine, cause the machine to perform the method of any one of examples 9 to 15.
17. An electronic badge for cooperating with the brain computer interface system of any one of examples 1 to 8, the electronic badge comprising a stimulus generator and at least one of the light emitting units.

## Claims

1. A brain computer interface system, comprising:
a light emitting unit (202, 410, 510, 610, 618) for outputting a visual stimulus generated by a stimulus generator (512, 612), the visual stimulus having a characteristic modulation selectively applied to a high spatial frequency (HSF) component of the visual stimulus;
a controllable object (210, 514, 604) configured to receive user instructions from a user, the controllable object (210, 514, 604) being associated with the visual stimulus output by the light emitting unit (202, 410, 510, 610, 618);
a neural signal capture device (206) configured to capture neural signals associated with the user;
an interfacing device (208) operatively coupled to the neural signal capture device (206) and the controllable object, the interfacing device (208) including:
a memory; and
a processor operatively coupled to the memory and configured to:
receive (704) the neural signals from the neural signal capture device (206);
determine (706) the visual stimuli is an object of attention of the user based on a presence in the neural signals of a component having a property associated with the characteristic modulation of the HSF component of the visual stimulus; and
transmit (708) a command to the controllable object determined associated with the visual stimulus,
wherein said controllable object implements an action based on said command.

2. The brain computer interface system of claim 1, wherein implementing the action comprises controlling said controllable object to change state from a standby state.

3. The brain computer interface system of claim 1 or claim 2, wherein the controllable object (210, 514, 604) includes the stimulus generator (512, 612) and the light emitting unit (202, 410, 510, 610, 618) for outputting the visual stimulus generated by the stimulus generator (512, 612).

4. The brain computer interface system of claim 1 or claim 2, wherein the stimulus generator (512, 612) and the light emitting unit (202, 410, 510, 610, 618) are provided in an electronic badge (620), the electronic badge (620) being separate from, but logically associated with, the controllable object (210, 514, 604).

5. The brain computer interface system of claim 1 or claim 2, wherein the light emitting unit (202, 410, 510, 610, 618) is a projector (510), the projector (510) being operatively coupled to the stimulus generator (512, 612) and projecting the visual stimulus onto the one controllable object (210, 514, 604) associated with the visual stimulus; and
wherein the controllable object (210, 514, 604) reflects the projected visual stimulus.

6. The brain computer interface system of any one of claims 1 to 4, wherein the light emitting unit (202, 410, 510, 610, 618) comprises at least one of: a single light emitting diode (LED); an array of LEDs; a liquid crystal display (LCD) device; or an organic light-emitting diode (OLED) display.

7. The brain computer interface system of any one of claims 1 to 6, further comprising a processing device, the processing device including the stimulus generator (512, 612), wherein the processing device is communicatively coupled with the interfacing device (208), the processing device configured to communicate information indicating the generated visual stimulus to the interfacing device (208).

8. A method of operation of a brain computer interface system, the brain computer interface system including a neural signal capture device (206) and a light emitting unit (202, 410, 510, 610, 618) for outputting a visual stimulus generated by a stimulus generator (512, 612), the visual stimulus having a characteristic modulation selectively applied to a high spatial frequency (HSF) component of the visual stimulus,
wherein the method comprises, in a hardware interfacing device (208) operatively coupled to the neural signal capture device (206) and a controllable real world object (210, 514, 604):
forming (702) an association between the controllable real world object (210, 514, 604) and the visual stimulus;
receiving (704) neural signals associated with a user captured by the neural signal capture device (206);
determining (706) the visual stimuli is an object of attention of the user based a presence in the neural signals of a component having a property associated with the characteristic modulation of the visual stimulus; and
transmitting (708) a command to the controllable object associated with the visual stimulus, thereby controlling said controllable object to implement an action based on said command.

9. The method of claim 8, wherein implementing the action comprises controlling said controllable object to change state from a standby state.

10. The method of claim 8 or claim 9, wherein the controllable real world object (210, 514, 604) includes the stimulus generator (512, 612) and the light emitting unit (202, 410, 510, 610, 618), and wherein forming (702) the association between the controllable real world object (210, 514, 604) and the visual stimulus includes controlling the light emitting unit (202, 410, 510, 610, 618) to output the visual stimulus generated by the stimulus generator (512, 612).

11. The method of claim 8 or claim 9, wherein the stimulus generator (512, 612) and the light emitting unit (202, 410, 510, 610, 618) are provided in an electronic badge (620), the electronic badge (620) being separate from the controllable real world object (210, 514, 604), and wherein forming (702) the association between the controllable real world object (210, 514, 604) and the visual stimulus includes logically associating the electronic badge (620) with the real world controllable object (210, 514, 604) and controlling the light emitting unit (618) of the electronic badge (620) to output the visual stimulus generated by the stimulus generator (512, 612).

12. The method of claim 8 or claim 9, wherein the light emitting unit (202, 410, 510, 610, 618) is a projector (510), the projector (510) being operatively coupled to the stimulus generator (512, 612), and wherein forming (702) the association between the controllable real world object (210, 514, 604) and the visual stimulus includes controlling the projector (510) to project the respective visual stimulus onto the real world controllable object (210, 514, 604), so that the real world controllable object (210, 514, 604) reflects the projected visual stimulus.

13. The method of any one of claims 8 to 12, wherein the brain computer interface system further comprises a processing device, the processing device including the stimulus generator (512, 612); wherein the processing device is communicatively coupled with the hardware interfacing device (208), and wherein forming the association between the controllable real world object (210, 514, 604) and the visual stimulus further comprises, causing the processing device to communicate information indicating the generated visual stimulus to the hardware interfacing device (208).

14. A computer-readable storage medium, the computer-readable storage medium including instructions that when executed by a processor, cause the processor to perform the method of any one of claims 8 to 13.

15. An electronic badge (620) for cooperating with the brain computer interface system of any one of claims 1 to 7, the electronic badge (620) comprising a badge stimulus generator (612') and a badge light emitting unit (618).
